# EUROPÄISCHE PATENTSCHRIFT

(11) **EP 3 883 354 B1**
(45) Veröffentlichungstag und Bekanntmachung des Hinweises auf die Patenterteilung: **01.11.2023**
(21) Anmeldenummer: 21154551.2
(22) Anmeldetag: 01.02.2021
(51) Int. Cl.: H05K 5/02

(54) **ELEKTRONIKGEHÄUSE MIT DICHTPRÜFÖFFNUNG UND DICHTSTOPFEN**
ELECTRONIC HOUSING WITH LEAK TEST OPENING AND SEALING PLUG
BOITIER ÉLECTRONIQUE POURVU D'OUVERTURE D'ESSAI D'ÉTANCHÉITÉ ET BOUCHON D'ÉTANCHÉITÉ

(30) Priorität: 17.03.2020 DE 102020107247
(43) Veröffentlichungstag der Anmeldung: 22.09.2021
(73) Patentinhaber: ebm-papst Mulfingen GmbH & Co. KG, 74673 Mulfingen (DE)
(72) Erfinder: FRIEDLEIN, Florian, 74747 Ravenstein-Hüngheim (DE); FRERICKS, Niclas, 97980 Bad Mergentheim (DE)
(74) Vertreter: Staeger & Sperling Partnerschaftsgesellschaft mbB

(56) Entgegenhaltungen:
- EP-A2- 2 495 848
- WO-A1-2011/072888
- DE-A1-102016 117 332

## Beschreibung

Die Erfindung betrifft ein Elektronikgehäuse zur Aufnahme von Elektronikbauteilen mit einer Dichtprüföffnung zur Durchführung einer Dichtheitsprüfung des Elektronikgehäuses.

Aus dem Stand der Technik sind Elektronikgehäuse bekannt, welche eine hohe IP-Schutzart erfüllen und zur Sicherstellung ihrer ausreichenden Dichtheit einer Dichtheitsprüfung unterzogen werden. Hierfür weist das Elektronikgehäuse eine Dichtprüföffnung auf, über die beispielsweise ein Unterdruck oder Überdruck im Elektronikgehäuse erzeugt wird. Nach erfolgreicher Dichtheitsprüfung des Elektronikgehäuses wird die Dichtprüföffnung durch eine Dichtniete oder eine Dichtschraube verschlossen. Zur Sicherstellung der ausreichenden Abdichtung der Dichtprüföffnung muss eine weitere Dichtheitsprüfung der verschlossenen Dichtprüföffnung erfolgen, um auszuschließen, dass die Dichtschraube oder der Dichtniet falsch montiert wurde oder Materialfehler vorliegen. Das ist aufwändig und kostenintensiv.

Die im Stand der Technik verwendeten Dichtschrauben weisen eine Unterkopfbeschichtung aus Kunststoff oder eine Mikroverkapselung auf. Die Dichtnieten sind teils mit speziellen Dichtbeschichtungen versehen. Zur Montage der Dichtniete ist ein Nietwerkzeug mit Zugkraftüberwachung einzusetzen, um eine festgelegte Position bzw. Verformung einzuhalten. Dabei kann jedoch eine Beschädigung des meist aus Kunststoff gefertigten Elektronikgehäuses nicht ausgeschlossen werden. Die Dichtschrauben werden mit festgelegtem Drehmoment und mithin ebenfalls mit einem Werkzeug verschraubt. Somit wird klar, dass die Befestigungsverfahren sehr genaue Prozesse und Gegenkonturen an der Dichtprüföffnung erfordern. Schwankungen im Montageprozess können dazu führen, dass die Dichtschraube nicht richtig abdichtet. Im Falle der Dichtniete und der Dichtschraube, meist aus metallischen Werkstoffen gebildet sind ist eine zuverlässige Abdichtung nach Temperaturwechseln, die im Falle eines Kunststoffgehäuses durch das Kriechen zu Setzungsverhalten führen und Mikrospalte zulassen, nicht mehr gewährleistet, was trotz geprüfter Dichtheit nach dem Verschließen im Betrieb zu einem Ausfall führen kann.

Druckschriftlicher Stand der Technik aus dem vorliegenden technischen Gebiet ist in den Dokumenten DE 10 2016 117 332 A1, EP 2 495 848 A2 und WO 2011/072888 A1 offenbart.

Der Erfindung liegt deshalb die Aufgabe zugrunde, ein gekapselt dichtes, insbesondere nach IP-Schutzart dichtes Elektronikgehäuse mit einer Abdichtung seiner Dichtprüföffnung zur Durchführung der Dichtheitsprüfung des Elektronikgehäuses bereitzustellen, welches dauerhafte temperaturunabhängige Abdichtung gewährleistet und eine zusätzliche Dichtheitsprüfung der Dichtprüföffnung selbst überflüssig macht.

Diese Aufgabe wird durch die Merkmalskombination gemäß Patentanspruch 1 gelöst.

Erfindungsgemäß wird ein Elektronikgehäuse zur Aufnahme von Elektronikbauteilen, insbesondere ein Ventilator-Elektronikgehäuse vorgeschlagen. Das Elektronikgehäuse ist gekapselt dicht, insbesondere nach einer IP-Schutzart ausgebildet und umfasst eine Dichtprüföffnung, die ausgebildet ist, eine Dichtheitsprüfung des gesamten Elektronikgehäuses durchzuführen. In der Dichtprüföffnung ist ein Dichtstopfen aus Silikon-Kautschuk angeordnet, der mehrere Dichtlippen aufweist, die an der Dichtprüföffnung dichtend anliegen und eine Mehrfachabdichtung bewirken.

Der Dichtstopfen und die Geometrie der Dichtprüföffnung sind vorzugsweise mit rundem Querschnitt ausgeführt. Alternative kann der Querschnitt auch oval oder in Spezialfällen auch eckig gebildet sein. Die Geometrie des Dichtstopfens und der Dichtprüföffnung sind jedoch stets aufeinander abgestimmt.

Mit dem Dichtstopfen aus Silikon-Kautschuk kann die Dichtprüföffnung prozesssicher abgedichtet und toleranzausgleichend bei thermischen Schwankungen verschlossen werden. Die Mehrzahl der Dichtlippen bietet eine ausreichende Sicherheit der Abdichtung der Dichtprüföffnung, so dass zusätzliche Dichtheitsprüfungen für die Dichtprüföffnung selbst entfallen können. Das Zusammenwirken von Dichtstopfen und Dichtprüföffnung richtet sich erfindungsgemäß ausschließlich auf diejenige Dichtprüföffnung, die dazu vorgesehen ist, die Dichtheitsprüfung des Elektronikgehäuses durchzuführen.

In einer kostengünstigen und montagefreundlichen Ausführung ist vorgesehen, dass der Dichtstopfen einstückig ausgebildet ist.

Ferner ist eine vorteilhafte Ausführung des Dichtstopfens dadurch gekennzeichnet, dass seine Dichtlippen in Reihe zueinander beabstandet angeordnet ausgebildet sind. Günstigerweise werden mindestens drei Dichtlippen vorgesehen, welche im bestimmungsgemäßen Gebrauch in der Dichtprüföffnung zur Anlage gebracht werden und eine Dreifachabdichtung gewährleisten.

Das Elektronikgehäuse erfüllt vorteilhafterweise eine sehr hohe Dichtheitsanforderung nach IP-Schutzart, vorzugsweise nach der IP-Schutzart IP6(k)9(k), IP68, IP6x oder weitere mögliche Kombinationen unabhängig vom IP-Schutzgrad, bei denen ein gekapseltes, abgeschlossenes Elektronikgehäuse notwendig ist, um ungewollten Medieneintritt zu verhindern. Um beispielsweise Material- oder Montagefehler der an der Sicherstellung der Dichtheit beteiligten Komponenten festzustellen, ist eine Dichtheitsprüfung essentiell um sicher gewährleisten zu können, dass keine Undichtheiten im Feldbetrieb auftreten. Umfasst sind auch Elektronikgehäuse, welche ein Druckausgleichselement aufweisen und dabei gleichwohl gekapselt sind, so dass sie wasser- und staubdicht, aber luftdurchlässig sind.

Besonders günstig bei dem Elektronikgehäuse ist eine Ausführung, wonach der Dichtstopfen händisch und werkzeugfrei in der Dichtprüföffnung montierbar ist. Der Dichtstopfen aus Silikon-Kautschuk wird manuell in die Dichtprüföffnung eingedrückt, bis alle Dichtlippen an der Innenwandfläche der Dichtprüföffnung anliegen. Vorzugsweise gibt es in der Dichtprüföffnung eine festgelegte Position für den Dichtstopfen, beispielsweise eine Markierung, hinter welche der Dichtstopfen zu drücken ist. Zudem weist der Dichtstopfen vorzugsweise eine ebene Fläche auf, über welche er in die Dichtprüföffnung eindrückbar ist. Die ebene Fläche kann zudem einen bündigen Übergang in einer Ebene zwischen der Außenwandung des Elektronikgehäuses und dem Dichtstopfen herstellen.

Bei größeren Stückzahlen wird allerdings vorzugsweise ein prozessüberwachtes, automatisiertes Montagesystem eingesetzt, welches sowohl das Einbringen des Dichtstopfens realisiert als auch dessen finale Position abfragt. Somit kann auf die zusätzliche Dichtheitsprüfung verzichtet werden.

Als günstiges Silikon-Material für den Dichtstopfen hat sich in der Praxis MVQ erwiesen. Deshalb sieht eine bevorzugte Ausführung dieses Material, beispielsweise als MVQ50 vor.

In einer erfindungsgemäßen Ausbildung ist das Elektronikgehäuse dadurch gekennzeichnet, dass der Dichtstopfen transluzent ausgebildet ist und Lichtsignale zwischen einem Gehäuseinneren und einer Gehäuseumgebung durch den Dichtstopfen übermittelbar sind. Über die Lichtsignale können Funktionen der Elektronik im Elektronikgehäuse gesteuert werden. In die mittels des Dichtstopfens abgedichtete Dichtprüföffnung ist somit eine weitere Funktion integrierbar, ohne dass zusätzliche Fenster in dem Elektronikgehäuse vorzusehen wären.

Eine günstige Ausführung des Elektronikgehäuses sieht dabei vor, dass angrenzend zu der Dichtprüföffnung ein Elektronikbauteil, insbesondere eine Leiterplatte, mit einer Photozelle in dem Gehäuseinneren des Elektronikgehäuses angeordnet ist, wobei die Photozelle der Dichtprüföffnung derart zugeordnet positioniert ist, dass ein Lichtsignal von der Gehäuseumgebung durch den Dichtstopfen auf die Photozelle übertragbar ist. Die Photozelle dient dann als Empfänger zur Umsetzung der z.B. getakteten Lichtsignale, welche eine Kommunikation beispielsweise des Kundendienstes mit der Elektronik im abgedichteten Elektronikgehäuse ermöglicht. Auch ist eine Programmierung, eine Programmauswahl oder Ventilatorkodierung der Elektronik über die Lichtsignale möglich. Anstelle einer Photozelle kann jedes Bauteil verwendet werden, das Lichtsignale bzw. optische Signale verarbeiten oder zumindest weiterleiten kann.

Eine weitere Ausführungsform des Elektronikgehäuses ist dadurch gekennzeichnet, dass angrenzend zu der Dichtprüföffnung ein Elektronikbauteil, insbesondere eine Leiterplatte, mit einer Lichtquelle in dem Gehäuseinneren des Elektronikgehäuses angeordnet ist, wobei ein von der Lichtquelle ausgesendetes Licht durch den Dichtstopfen aus der Gehäuseumgebung erfassbar ist. Die Lichtquelle ist vorzugsweise als Leuchtdiode ausgebildet. Es können somit von der Elektronik über die Leuchtdiode Informationen visuell an die Gehäuseumgebung abgegeben und beispielsweise Störungen oder Programminformationen anhand eines Lichtsignals erfasst werden.

Eine Weiterbildung sieht zudem vor, einen Code auf dem Elektronikgehäuse aufzubringen, z.B. per Plakette oder Aufkleber, der das auf die Photozelle zu übertragende Lichtsignal in einen Befehl oder das von der Leuchtquelle ausgesendete Lichtsignal in einen Bedeutungsinhalt übersetzt. Alternativ kann der Code auch durch die Gehäusewandung des Elektronikgehäuses selbst widergegeben werden und ist somit beispielsweise in den Kunststoff eingraviert oder eingepresst.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: ein erstes Ausführungsbeispiel eines Elektronikgehäuses,
- Fig. 2: ein zweites Ausführungsbeispiel eines Elektronikgehäuses.

Die Figuren sind beispielhaft schematisch, die gezeichneten Merkmale sind jedoch Bestandteil der Offenbarung.

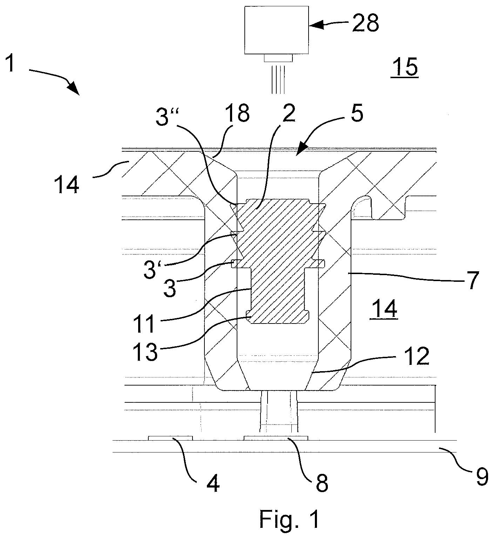

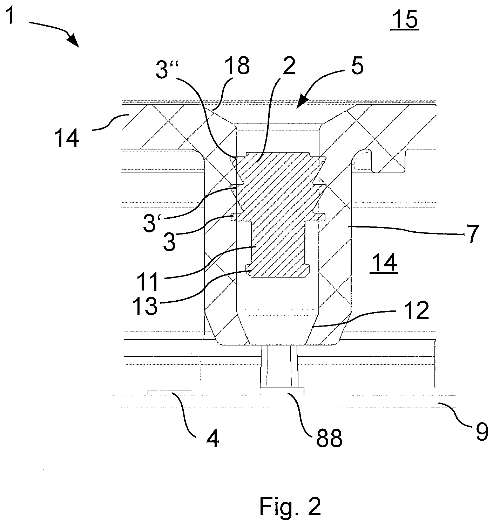

In den Figuren 1 und 2 sind zwei Ausführungsbeispiele eines Elektronikgehäuses 1 dargestellt. Da die wesentlichen Merkmale übereinstimmen, werden beiden Figuren zunächst zusammen beschrieben, im Anschluss werden die Unterschiede dargestellt.

Das Elektronikgehäuse 1 ist ein an einem Ventilator verwendetes Gehäuse, in dem die in der Technik bekannten, zur Regelung des Antriebsmotors verwendeten Elektronikbauteile aufgenommen sind. Beispielhaft ist hierfür eine Leiterplatte 9 mit einem angedeuteten Elektronikbauteil 4 gezeigt. Das Elektronikgehäuse 1 ist mit einer Gehäusewand 14 vorzugsweise einstückig aus Kunststoff gefertigt und dicht nach z.B. der IP-Schutzart IP6k9k. Zur Dichtheitsprüfung ist die Dichtprüföffnung 5 in dem Elektronikgehäuse 1 vorgesehen, welche durch einen sich ins Gehäuseinnere 14 erstreckenden, gewindefreien Rohrabschnitt 7 gebildet ist. In der Dichtprüföffnung 5 ist der einstückige Dichtstopfen 2 aus Silikon-Kautschuk, vorzugsweise aus MVQ50, eingedrückt und liegt mit seinen drei in Reihe angeordneten und jeweils axial beabstandeten Dichtlippen 3, 3', 3" an der Innenwandfläche des Rohrabschnitts 7 an. Der Einlass in die Dichtprüföffnung 5 weist Schrägen 18 auf, welche eine gerade Zuführung des Dichtstopfens 2 ermöglichen und ein Verkanten vermeiden. Am freien Ende 12 ist der Rohrabschnitt 7 der Dichtprüföffnung 5 eingezogen ausgebildet, so dass sich die Querschnittsfläche des Innenrohres verringert. Somit ist ein zu tiefes Einstecken des Dichtstopfens 2 ausgeschlossen. Die zwei Dichtlippen 3', 3" weisen eine identische geometrische Dreiecksform auf, sind jedoch geometrisch unterschiedlich zur Dichtlippe 3, welche als geradlinig nach radial außen verlaufender Steg gebildet ist. Die drei Dichtlippen 3, 3', 3" erzeugen eine Mehrfachabdichtung und bieten eine hohe Sicherheit, so dass eine zusätzliche Dichtheitsprüfung nach dem Eindrücken des Dichtstopfens 2 nicht nötig ist. An die letzte Dichtlippe 3 angrenzend weist der Dichtstopfen 2 einen freien Schenkel 11 auf, dessen freies Ende mit einer Aufdickung 13 nach radial außen versehen ist.

Der Dichtstopfen 2 weist eine zur Gehäuseumgebung 15 weisende flache und ebene Oberfläche auf. Diese Oberfläche ist geeignet, um mit dem Finger den Dichtstopfen 2 in die Dichtprüföffnung 5 zu drücken, ohne dass es eines Werkzeugs bedarf. Bei einer Positionierung beispielsweise durch ein automatisiertes Werkzeug kann die ebene Oberfläche ebenfalls für eine optimale Positionierung des Dichtstopfens 2 genutzt werden. Der Dichtstopfen 2 ist zudem transluzent ausgebildet.

Gemäß der Ausführung in Figur 1 ist gezeigt, dass mit einer in der Gehäuseumgebung 15 positionierten oder beispielsweise einem Techniker gehaltenen Lampe 28 durch den Dichtstopfen 2 hindurch auf eine auf der Leiterplatte 9 der Dichtprüföffnung 5 zugeordnet positionierte Photozelle 8 geleuchtet werden kann. Die flache ebene Oberfläche des Dichtstopfens 2 ist hierbei besonders vorteilhaft, um die Lichtstrahlen mit wenig Streuung weiterzuleiten. Über spezielle Lichttaktungen der Lichtsignale können somit beispielsweise Befehle über die Photozelle 8 an die Elektronik im Gehäuseinneren 14 übertragen werden. Der Dichtstopfen 2 funktioniert somit neben seiner Aufgabe zur Abdichtung der Dichtprüföffnung 5 zudem als Fenster zwischen dem Gehäuseinneren 14 und der Gehäuseumgebung 15.

Figur 2 zeigt eine alternative Ausführung, bei der anstelle der Photozelle 8 auf der Leiterplatte 9 eine Lichtquelle 88 in Form einer Leuchtdiode angeordnet ist. Ein von der Leuchtdiode erzeugtes Lichtsignal, z.B. Wartungsbedarf, Fehlermeldung, etc. kann aus der Gehäuseumgebung 15 durch den transluzenten Dichtstopfen 2 erfasst werden. Hierfür können bei der Lichtquelle unterschiedliche Lichtfarben und Leuchtfrequenzen eingesetzt werden.

Natürlich ist zudem auch eine Ausführung möglich und von der Offenbarung umfasst, bei der sowohl eine Photozelle 8 als auch eine Lichtquelle 88 vorgesehen sind, um beispielsweise über die Lampe 28 eingegebene Befehle über die Lichtquelle 88 bestätigt zu erhalten oder Fehlermeldungen auszugeben.

Ein Code für die mit der Lampe 28 einzugebende Lichttaktung und/oder für die durch das Leuchtmittel 88 ausgegebenen Lichtsignale ist entweder auf der Gehäusewandung 14 aufgeklebt oder wird durch die Gehäusewandung 14 selbst wiedergegeben. Bei letzterer ist der Code im Kunststoff der Gehäusewandung 14.

## Patentansprüche

1. Elektronikgehäuse (1) zur Aufnahme von Elektronikbauteilen (4), insbesondere Ventilator-Elektronikgehäuse, wobei das Elektronikgehäuse (1) dicht gekapselt, insbesondere nach einer IP-Schutzart ausgebildet ist und eine Dichtprüföffnung (5) umfasst, die ausgebildet ist, eine Dichtheitsprüfung des gesamten Elektronikgehäuses (1) durchzuführen, wobei in der Dichtprüföffnung (5) ein Dichtstopfen (2) aus Silikon-Kautschuk angeordnet ist, der mehrere Dichtlippen (3, 3', 3") aufweist, die an der Dichtprüföffnung (5) dichtend anliegen und eine Mehrfachabdichtung bewirken, wobei, der Dichtstopfen (2) transluzent ausgebildet ist und Lichtsignale zwischen einem Gehäuseinneren (14) und einer Gehäuseumgebung (15) durch den Dichtstopfen (2) übermittelbar sind.

2. Elektronikgehäuse nach Anspruch 1, **dadurch gekennzeichnet, dass** der Dichtstopfen (2) einstückig ausgebildet ist.

3. Elektronikgehäuse nach Anspruch 1 oder 2, **dadurch gekennzeichnet, dass** die Dichtlippen (3, 3', 3") des Dichtstopfens (2) in Reihe zueinander beabstandet angeordnet ausgebildet sind und eine unterschiedliche geometrische Form aufweisen.

4. Elektronikgehäuse nach einem der vorigen Ansprüche, **dadurch gekennzeichnet, dass** der Dichtstopfen (2) ausgebildet ist, händisch und werkzeugfrei in der Dichtprüföffnung (5) montiert zu werden.

5. Elektronikgehäuse nach einem der vorigen Ansprüche, **dadurch gekennzeichnet, dass** der Dichtstopfen (2) aus Silikon-Kautschuk MVQ gebildet ist.

6. Elektronikgehäuse nach einem der vorigen Ansprüche, **dadurch gekennzeichnet, dass** angrenzend zu der Dichtprüföffnung (5) ein Elektronikbauteil mit einer Photozelle (8) in dem Gehäuseinneren (14) des Elektronikgehäuses (1) angeordnet ist, wobei die Photozelle (8) der Dichtprüföffnung (5) zugeordnet positioniert ist, dass ein Lichtsignal von der Gehäuseumgebung (15) durch den Dichtstopfen (2) auf die Photozelle (8) übertragbar ist.

7. Elektronikgehäuse nach einem der vorigen Ansprüche, **dadurch gekennzeichnet, dass** angrenzend zu der Dichtprüföffnung (5) ein Elektronikbauteil mit einer Lichtquelle (28) in dem Gehäuseinneren (14) des Elektronikgehäuses (1) angeordnet ist, wobei ein von der Lichtquelle (88) ausgesendetes Lichtsignal durch den Dichtstopfen (2) aus der Gehäuseumgebung (15) erfassbar ist.

8. Elektronikgehäuse nach dem vorigen Anspruch, **dadurch gekennzeichnet, dass** die Lichtquelle (88) als Leuchtdiode ausgebildet ist.

9. Elektronikgehäuse nach einem der vorigen Ansprüche 6 - 8, **dadurch gekennzeichnet, dass** auf dem Elektronikgehäuse (1) ein Code aufgebracht ist, der das auf die Photozelle zu übertragende Lichtsignal in einen Befehl oder das von der Leuchtquelle ausgesendete Lichtsignal in einen Bedeutungsinhalt übersetzt.

10. Elektronikgehäuse nach dem vorigen Anspruch, **dadurch gekennzeichnet, dass** der Code durch eine Gehäusewandung (14) des Elektronikgehäuses wiedergegeben ist.

## Claims

1. An electronics housing (1) for accommodating electronic components (4), in particular a fan electronics housing, wherein the electronics housing (1) is tightly encapsulated, in particular designed according to an IP protection class, and comprises a leak test opening (5) designed to perform a leak test of the entire electronics housing (1), wherein, in the leak test opening (5), a sealing plug (2) made of silicone rubber is arranged, which has multiple sealing lips (3, 3', 3") closely abutting the leak test opening (5) and causing a multi-sealing effect, wherein the sealing plug (2) is designed to be translucent, and light signals are able to be transmitted between a housing interior (14) and a housing environment (15) through the sealing plug (2).

2. The electronics housing according to claim 1, **characterized in that** the sealing plug (2) is designed integrally.

3. The electronics housing according to claim 1 or 2, **characterized in that** the sealing lips (3, 3', 3") of the sealing plug (2) are arranged spaced apart from one another in a row and have different geometric shapes.

4. The electronics housing according to any one of the preceding claims, **characterized in that** the sealing plug (2) is designed to be installed in the leak test opening (5) manually and without tools.

5. The electronics housing according to any one of the preceding claims, **characterized in that** the sealing plug (2) is formed from MVQ silicone rubber.

6. The electronics housing according to any one of the preceding claims, **characterized in that** an electronic component with a photocell (8) is arranged in the housing interior (14) of the electronics housing (1) adjacent to the leak test opening (5), wherein the photocell (8) is positioned to be associated with the leak test opening (5), so that a light signal is able to be transmitted from the housing environment (15) through the sealing plug (2) onto the photocell (8).

7. The electronics housing according to any one of the preceding claims, **characterized in that** an electronic component with a light source (28) is arranged in the housing interior (14) of the electronics housing (1) adjacent to the leak test opening (5), wherein a light signal emitted by the light source (88) is able to be sensed through the sealing plug (2) from the housing environment (15).

8. The electronics housing according to any one of the preceding claims, **characterized in that** the light source (88) is designed as a light-emitting diode.

9. The electronics housing according to any one of preceding claims 6-8, **characterized in that** a code is applied to the electronics housing (1), which translates the light signal to be transmitted onto the photocell into a command or translates the light signal emitted by the light source into meaningful content.

10. The electronics housing according to any one of the preceding claims, **characterized in that** the code is reproduced by a housing wall (14) of the electronics housing.

## Revendications

1. Boîtier électronique (1) destiné à recevoir des composants électroniques (4), en particulier un boîtier électronique de ventilateur, dans lequel le boîtier électronique (1) est encapsulé de manière étanche, en particulier réalisé selon un type de protection IP, et comprend une ouverture de contrôle d'étanchéité (5) qui est réalisée pour effectuer un contrôle d'étanchéité de l'ensemble du boîtier électronique (1), dans lequel dans l'ouverture de contrôle d'étanchéité (5) est disposé un bouchon d'étanchéité (2) en caoutchouc silicone qui présente plusieurs lèvres d'étanchéité (3, 3', 3") qui s'appliquent de manière étanche contre l'ouverture de contrôle d'étanchéité (5) et provoquent une étanchéité multiple, dans lequel le bouchon d'étanchéité (2) est réalisé de manière translucide et des signaux lumineux peuvent être transmis à travers le bouchon d'étanchéité (2) entre l'intérieur du boîtier (14) et un environnement du boîtier (15).

2. Boîtier électronique selon la revendication 1, **caractérisé en ce que** le bouchon d'étanchéité (2) est réalisé d'un seul tenant.

3. Boîtier électronique selon la revendication 1 ou 2, **caractérisé en ce que** les lèvres d'étanchéité (3, 3', 3") du bouchon d'étanchéité (2) sont réalisées en étant disposées en ligne, de manière espacée les unes par rapport aux autres, et présentent différentes formes géométriques.

4. Boîtier électronique selon l'une quelconque des revendications précédentes, **caractérisé en ce que** le bouchon d'étanchéité (2) est réalisé pour être monté manuellement et sans outil dans l'ouverture de contrôle d'étanchéité (5).

5. Boîtier électronique selon l'une quelconque des revendications précédentes, **caractérisé en ce que** le bouchon d'étanchéité (2) est formé en caoutchouc silicone MVQ.

6. Boîtier électronique selon l'une quelconque des revendications précédentes, **caractérisé en ce qu'**un composant électronique pourvu d'une cellule photoélectrique (8) est disposé de manière adjacente à l'ouverture de contrôle d'étanchéité (5) à l'intérieur du boîtier (14) du boîtier électronique (1), dans lequel la cellule photoélectrique (8) est positionnée en étant associée à l'ouverture de contrôle d'étanchéité (5), **en ce qu'**un signal lumineux peut être transmis à travers le bouchon d'étanchéité (2) de l'environnement du boîtier (15) à la cellule photoélectrique (8).

7. Boîtier électronique selon l'une quelconque des revendications précédentes, **caractérisé en ce qu'**un composant électronique pourvu d'une source de lumière (28) est disposé de manière adjacente à l'ouverture de contrôle d'étanchéité (5) à l'intérieur du boîtier (14) du boîtier électronique (1), dans lequel un signal lumineux émis par la source de lumière (88) peut être détecté à travers le bouchon d'étanchéité (2) à partir de l'environnement du boîtier (15).

8. Boîtier électronique selon la revendication précédente, **caractérisé en ce que** la source de lumière (88) est réalisée sous forme de diode électroluminescente.

9. Boîtier électronique selon l'une quelconque des revendications précédentes 6 à 8, **caractérisé en ce que** sur le boîtier électronique (1) est appliqué un code qui convertit le signal lumineux à transmettre à la cellule photoélectrique en une commande ou convertit le signal lumineux émis par la source lumineuse en un contenu significatif.

10. Boîtier électronique selon la revendication précédente, **caractérisé en ce que** le code est reproduit à travers une paroi de boîtier (14) du boîtier électronique.
